(19) **Europäisches Patentamt European Patent Office Office européen des brevets**

(11) **EP 4 730 795 A1**

(12) **EUROPEAN PATENT APPLICATION**

(43) Date of publication:
22.04.2026 Bulletin 2026/17

(21) Application number: 24306761.8

(22) Date of filing: 21.10.2024

(51) International Patent Classification (IPC):
**H04N 19/13** (2014.01)     **H03M 7/40** (2006.01)

(52) Cooperative Patent Classification (CPC):
**H04N 19/13; H03M 7/4018; H04N 19/91**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **InterDigital CE Patent Holdings, SAS 75017 Paris (FR)**

(72) Inventors:
• **BALCILAR, Muhammet 35830 BETTON (FR)**
• **LO BIANCO, Federico 35700 RENNES (FR)**
• **SALMON-LEGAGNEUR, Charles 35000 RENNES (FR)**
• **GALPIN, Franck 35235 THORIGNE-FOUILLARD (FR)**

(74) Representative: **Vossius & Partner Patentanwälte Rechtsanwälte mbB Siebertstraße 3 81675 München (DE)**

(54) **ENTROPY CODING OF ON THE BORDER PREDICTED PROBABILITIES**

(57)     Systems, methods, and instrumentalities are disclosed for entropy coding of on the border predicted probabilities. A context adaptive binary arithmetic coding (CABAC) probability associated with a bit may be determined. A range of a least probable symbol (LPS) may be determined based on the CABAC probability and a probability prediction threshold. The bit may be entropy decoded or encoded based on the range of the LPS. The range of the LPS may be determined to be a minimum range value based on the CABAC probability being less than or equal to the probability prediction threshold. The probability prediction threshold may be a first probability prediction threshold. A second probability prediction threshold may be determined that is greater than the first probability prediction threshold.

**FIG. 7**

## Description

### BACKGROUND

The present application is related to video coding systems that may be used to compress digital video signals, e.g., to reduce the storage and/or transmission bandwidth needed for such signals. Video coding systems may include, for example, block-based, wavelet-based, and/or object-based systems.

### BRIEF SUMMARY

Systems, methods, and instrumentalities are disclosed for entropy coding of on the border predicted probabilities. A context adaptive binary arithmetic coding (CABAC) probability associated with a bit may be determined. A range of a least probable symbol (LPS) may be determined based on the CABAC probability and a probability prediction threshold. The bit may be entropy decoded or encoded based on the range of the LPS.

In examples, the range of the LPS may be determined to be a minimum range value based on the CABAC probability being less than or equal to the probability prediction threshold. The probability prediction threshold may be a first probability prediction threshold. A second probability prediction threshold may be determined that is greater than the first probability prediction threshold.

In examples, the range of the LPS may be determined to be a minimum range value based on the CABAC probability being greater than or equal to the second probability prediction threshold. A CABAC range adjustment parameter may be obtained. An interval range may be determined based on the CABAC range adjustment parameter. The determined interval range may be updated based on the minimum range value of the range of the LPS.

In examples, the probability prediction threshold may be a first probability prediction threshold. A second probability prediction threshold may be determined that is greater than the first probability prediction threshold. A CABAC range adjustment parameter may be obtained. An interval range may be determined based on the CABAC range adjustment parameter. A condition may be that the CABAC probability is greater than the first probability prediction threshold and less than the second probability prediction threshold. The range of the LPS may be determined further based on the determined interval range.

In examples, it may be determined that the bit is a significant bit of a transform coefficient associated with a coding block. The determination of the range of the LPS may be further based on the bit being a significant bit which may show whether the coefficient is different than zero of the transform coefficient associated with the coding block.

In examples, it may be determined that the bit is a significant bit of a transform coefficient associated with a coding block. A quantization state associated with the significant bit may be determined to be an odd state. The determination of the range of the LPS may be further based on the determination that the bit is a significant bit of the transform coefficient associated with the coding block and the determination that the quantization state associated with the significant bit is an odd state. The transform coefficient may be the earliest transform coefficient of a plurality of transform coefficients associated with coding block.

### BRIEF DESCRIPTION OF THE DRAWINGS

The following detailed description will be better understood when read in conjunction with the appended drawings, in which there are shown examples of one or more of the multiple embodiments of the present disclosure. It should be understood, however, that the embodiments described herein are not limited to the precise arrangements and instrumentalities shown in the drawings.

FIG. 1 shows an example system according to one or more embodiments of the present disclosure.
FIG. 2 shows an example video encoder according to one or more embodiments of the present disclosure.
FIG. 3 shows an example video decoder according to one or more embodiments of the present disclosure.
FIG. 4 shows a flowchart of an overview of entropy coding.
FIG. 5 shows parameters initialized at the beginning of a (e.g., each) slice.
FIG. 6 shows the overall Context Adaptive Binary Arithmetic Coder (CABAC) engine.
FIG. 7 shows a flowchart for decoding a single binary decision.

### DETAILED DESCRIPTION

In describing the various embodiments of the present disclosure, certain terminology is used herein for convenience only and should not be considered as limiting such embodiments. In the drawings, the same reference numerals are employed for designating the same elements throughout the several figures and the present description.

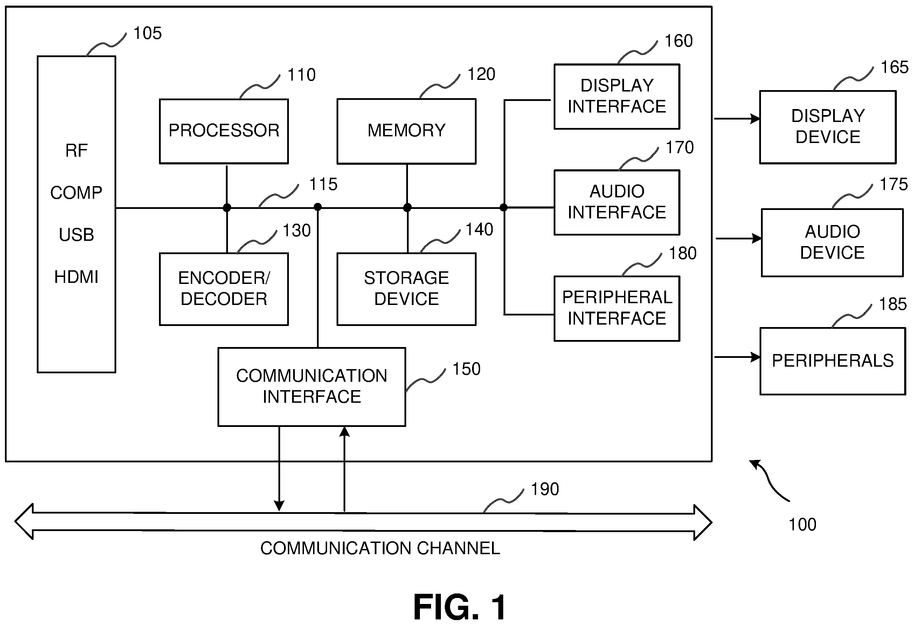

Referring to the drawings, there is shown in FIG. 1 a block diagram illustrating an example system 100 in which embodiments of the present disclosure can be implemented. The system 100 may be an electronic device including, for example, a personal computer, laptop computer, mobile phone, tablet computer, multimedia set-top box, digital television receiver, personal video recording system, connected home appliance, vehicle control and/or entertainment system, and server. One or more elements of the system 100, singly or in combination, may be implemented as an integrated circuit (IC), multiple ICs, and/or discrete components. For example, in one embodiment, the processing, encoding and/or decoding elements of system 100 are distributed across multiple ICs and/or discrete components. In some embodiments, the system 100 is communicatively coupled to and/or in communication with other systems or devices, via, for example, a communications bus or dedicated input/output ports.

One or more of the elements of system 100 may be provided within an integrated housing, with such elements being interconnected and able to transmit data therebetween using any suitable connection arrangement 115 generally known in the art, including, for example, an internal bus (e.g., I2C bus), wiring, and printed circuit boards.

The system 100 may include at least one processor 110 configured to execute instructions for implementing the embodiments described herein, including signal/data coding and processing. The processor 110 may be a general-purpose processor or microprocessor, digital signal processor (DSP), one or more microprocessors in association with a DSP core, a controller, a microcontroller, application specific integrated circuits (ASICs), field programmable gate arrays (FPGAs), a state machine, and the like. The processor 110 may include at least one central processing unit (CPU), embedded memory, input and output interfaces, and other circuitries.

The system 100 may include at least one memory 120, for example, a volatile memory device and/or a non-volatile memory device. The system 100 may include a storage device 140, that may be or include non-volatile memory and/or dynamic volatile memory, including EEPROM, ROM, PROM, RAM, DRAM, SRAM, DDR, flash, magnetic disk drives, solid state drives (SSD) and/or optical disk drives. The storage device 140 may be or include, for example, an internal storage device, an attached storage device, and/or a network accessible storage device. Although shown separately, the memory 120 and the storage device 140 may be collocated, integrated together, or otherwise combined.

The system 100 may include an encoder/decoder module 130 configured to process video data and to provide encoded video data or decoded video data. The encoder/decoder module 130 may include one or more processors and/or memory (not shown). Although FIG. 1 depicts the encoder/decoder module 130 as a separate element of system 100, it will be understood that the processor 110 and the encoder/decoder module 130 may be collocated and/or integrated together as a combination of hardware and/or software, e.g., in an electronic package or chip. The encoder/decoder module 130 may be or include one or more modules that may be included in one or more separate devices that perform encoding and/or decoding functions.

Instructions for execution by the processor 110 and/or the encoder/decoder module 130 may be stored in the storage device 140 and subsequently loaded into memory 120 for execution by the processor 110. In some embodiments, one or more of processor 110, memory 120, storage device 140, and encoder/decoder module 130 may store one or more items when performing the processes disclosed herein. Such items may include input video, decoded video or portions thereof, bitstreams, matrices, variables, operational logic, and intermediate and/or final results from processing of equations, formulas, or operations.

In some embodiments, the memory of the processor 110 and/or the encoder/decoder module 130 may be used to store instructions and/or provide working memory for video encoding and decoding functions. In some embodiments, memory external to the processor 110 and/or the encoder/decoder module 130 (e.g., the memory 120 and/or the storage device 140) may be used for one or more of these functions and/or, for example, to store the operating system of a television.

The system 100 may obtain or receive information via one or more input devices, interfaces, and/or ports as indicated in input block 105. Examples of the input devices include a radio frequency (RF) device for transmitting and/or receiving RF signals over various media, for example, RF signals received over the air from a broadcaster; component video (COMP) inputs; a Universal Serial Bus (USB) input; and/or a High-Definition Multimedia Interface (HDMI) input. Other examples include composite video input (not shown). In some embodiments, the input devices are associated with respective input processing elements, e.g., those generally known in the art. For example, the RF device may be associated with elements suitable for selecting a desired frequency (e.g., selecting or band-limiting a signal) or performing error correction on the signal. The USB and/or HDMI inputs may include respective interface processors and transceivers (or transmitters and receivers) for coupling the system 100 to other devices via USB and/or HDMI ports or connections. Various forms of input processing may be implemented, for example, by and/or within a separate input processing device or the processor 110.

The system 100 may include a communication interface 150 that enables wired and/or wireless communication with other devices, e.g., via a communication channel 190. The communication interface 150 may include one or more transceivers, modems, network cards and the like. The communication channel 190 may be or include wired and/or wireless mediums.

In some embodiments, data may be streamed to the system 100 via wired and/or wireless networks. Examples of such wireless networks include cellular, Bluetooth or Wi-Fi (e.g., IEEE 802.11) networks. The wired and/or wireless networks may include one or more base stations (e.g., cellular base stations, access points, etc.), and/or user equipment (e.g. cellular user equipment, stations, etc.), and/or other network elements that communicate with the system 100 via the communication interface 150 and communication channel 190, whereby the system 100 may obtain data streamed from streaming applications (e.g., OTT services) via various networks, including the Internet. In some embodiments, data is streamed to the system 100 via the input block 105 (e.g., using a set-top box that delivers data via the HDMI connection or the RF connection). In some embodiments, data is received by the system 100 in a non-streaming manner.

The system 100 may provide one or more output signals to one or more output devices. The output devices may include a display device 165 (e.g., touchscreen display, monitor, etc.), an audio device 175 (e.g., speakers), and other peripheral devices 185, including, for example, a stand-alone DVR, a disk player, a stereo system, a lighting system, and other devices that provide a function based on the output of the system 100. The display device 165 can be for a television, tablet, laptop, mobile phone, head-mounted display, or other device. In some embodiments, control signals are communicated between the system 100 and the display device 165, the audio device 175, and/or the peripheral devices 185, enabling device-to-device control with or without user intervention. The output devices may couple to and/or communicate with the system 100 via dedicated connections via respective display, audio, and peripheral interfaces 160, 170, 180. Alternatively, the output devices may couple to and/or communicate with the system 100 via the communication channel 190 and the communication interface 150.

The display device 165 and the audio device 175 may be collocated, integrated, or otherwise combined with the other components of system 100 in a single unit (e.g., a television). Alternatively, the display device 165 and the audio device 175 may be separate from one or more of the other components of the system 100. In embodiments in which the display device 165 and the audio device 175 are external components, the output signals may be provided via dedicated outputs and/or connections, including, for example, HDMI ports, USB ports, or COMP outputs.

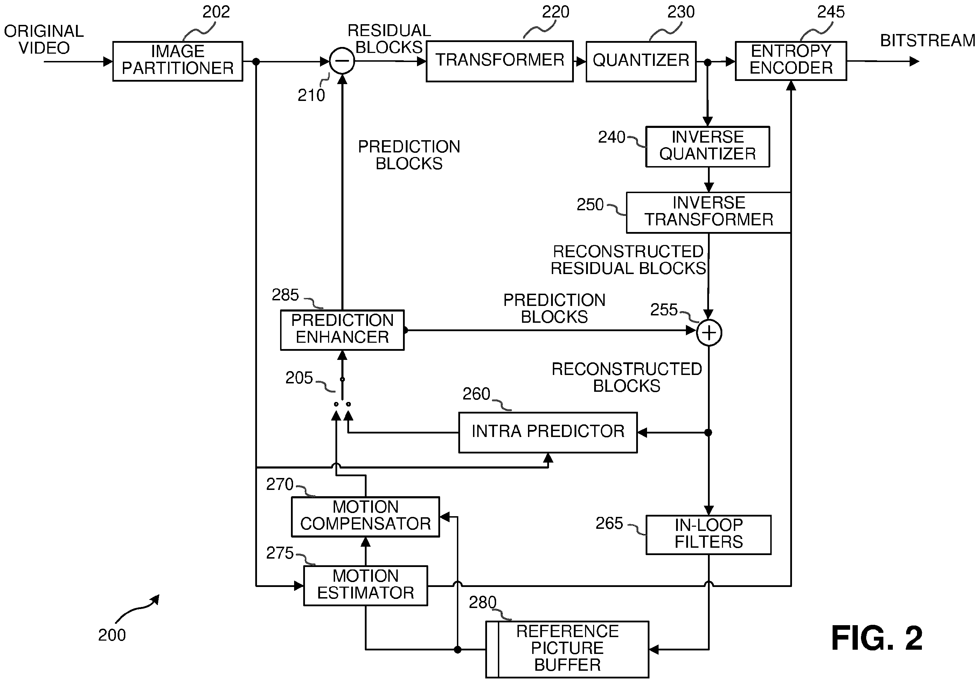

FIG. 2 is a block diagram illustrating an example video encoder 200 that may be employed by the system 100 (e.g., via the encoder/decoder module 130) described with respect to FIG. 1. The video encoder 200 may be an encoder that employs video compression technologies, standards, specification, or protocols, including Advanced Video Coding (AVC, H.264/MPEG-4), High Efficiency Video Coding (HEVC, H.265), Versatile Video Coding (WC, H.266), Essential Video Coding (EVC, MPEG-5), AOMedia Video 1 (AV1), VP9, or the Enhanced Compression Model (ECM), and variations or improvements thereof. Those skilled in the art will understand that the various embodiments described herein are not limited to a specific standard and can be applied to other standards and recommendations, as well as extensions thereof.

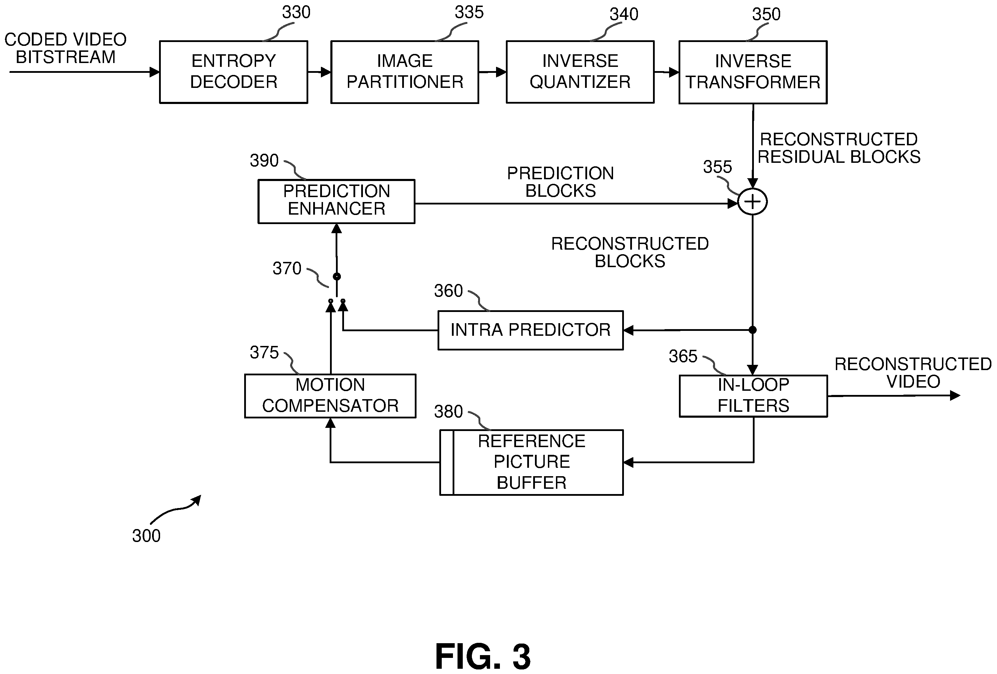

Some embodiments disclosed herein are described with reference to a coding unit (CU) or block of a video frame (or a video image or picture) to which coding tools may be applied by the video encoder 200 and/or by the video decoder 300 (described below with reference to FIG. 3). Generally, embodiments described herein may be applied to a video region formed by a video partition of any shape or size. The video region may be a video slice, a coding tree unit (CTU), or a CU (to which inter prediction or intra prediction can be applied), or a partition thereof, each of which can include samples of a luma component, Y, and chroma components, U and V (also denoted herein by C, $Cb$, $C_r$).

Referring generally to FIG. 2 and the video encoder 200, video data (e.g., one or more video frames) is encoded generally as described below. Prior to encoding, video data may be pre-processed by a precoding processor (not shown). The pre-processing may include, for example, applying a color model transform to the input color components of the input video data (e.g., conversion from RGB 4:4:4 to YUV 4:2:0) or mapping the color components of the input video data to obtain a signal distribution that is more resilient to compression (for instance, applying a histogram equalizer and/or a denoising filter to one or more of the video data's color components). The pre-processing may include associating metadata (for example, a supplemental enhancement information (SEI) message) with the video data that can be attached to a coded video bitstream. After pre-processing, if any, an image (frame) to be encoded is partitioned into CUs (blocks) by an image partitioner 202.

In general, a CU may include a luma block and associated chroma blocks. As such, functions of the video encoder 200 described herein as applied to a CU refer generally to the luma block and the respective chroma blocks. The CUs may be encoded using an intra prediction mode performed by an intra predictor 260. In intra prediction mode, the content of a CU in a frame is predicted based on content from one or more other CUs of the same frame (or region), using reconstructed blocks of other CUs output from an adder 255. The CUs may also or alternatively be encoded using an inter prediction mode, in which motion estimation and motion compensation are performed by a motion estimator 275 and a motion compensator 270, respectively. In inter prediction mode, the content of a CU in a frame is predicted based on content from one or more reconstructed areas of reference frames, available from a reference picture buffer 280.

The video encoder 200 selects or otherwise determines at 205 which prediction mode (intra prediction mode and/or inter prediction mode) to use for encoding a CU. The selected prediction mode may be enhanced (e.g., filtered) by a prediction enhancer 285. Based on the selected mode, a prediction for the CU is generated. A residual block is determined based on the prediction (e.g., prediction block, predicted CU) and the input CU. In some embodiments, such determination is made by a subtractor 210.

The residual block or a partition thereof (e.g., a transform block) is transformed into transform coefficients by a transformer 220. The transform coefficients are quantized by a quantizer 230. An entropy encoder 245 performs entropy encoding of the quantized transform coefficients and coding parameters (e.g., syntax elements including motion vectors and other control data) to form a bitstream of coded video data.

In addition to coding the original video blocks as described herein, the video encoder 200 reconstructs the coded blocks to provide references for future predictions. Thus, quantized transform coefficients (from the quantizer 230) are de-quantized by an inverse quantizer 240, and inverse transformed by an inverse transformer 250, to reconstruct (decode) the residual blocks. The reconstructed residual blocks and prediction blocks are combined (e.g., by the adder 255) to form reconstructed blocks. Thus, the video encoder 200 performs decoding operations through which the encoded images (frames) are reconstructed.

In-loop filters 265 may be applied to the reconstructed image (formed by the reconstructed blocks). The filtered reconstructed image(s) are stored in the reference picture buffer 280 and used by the motion estimator 275 and motion compensator 270, as explained above. The in-loop filters 265 can be applied to the reconstructed samples of an image to reduce distortions introduced by the encoding process. For example, a deblocking filter (DBF), bilateral filter (BIF), sample adaptive offset (SAO), and/or adaptive loop filter (ALF) can be applied to reduce encoding artifacts.

FIG. 3 is a block diagram illustrating an example of video decoder 300 that may be employed by the system 100 (e.g., via the encoder/decoder module 130) described with respect to FIG. 1. Generally, operational features of the video decoder 300 are reciprocal to operational features of the video encoder 200. In the video decoder 300, a coded video bitstream (e.g., generated by the video encoder 200 or another video encoding device or process) is entropy-decoded by an entropy decoder 330 to obtain transform coefficients, motion vectors, and other coding parameters. Based on the coding parameters, an image partitioner 335 divides the picture accordingly. The quantized transform coefficients are de-quantized by an inverse quantizer 340 and inverse transformed by an inverse transformer 350 to decode (e.g., reconstruct) respective residual blocks. Depending on the selected prediction mode, a predicted block can be obtained at 370 from an intra predictor 360 (e.g., intra prediction) or from a motion compensator 375 (e.g., inter prediction) and may be enhanced (e.g., filtered) by a prediction enhancer 390, generating a prediction block. The reconstructed residual blocks are combined with prediction blocks (e.g. by an adder 355), resulting in reconstructed blocks.

In-loop filters 365 (e.g., DBF, BIF, SAO, and/or ALF) can be applied to the reconstructed image (formed by the reconstructed blocks), to output reconstructed (decoded) video. The filtered reconstructed image is also stored in a reference picture buffer 380 for reference by the motion compensator 375.

A post-decoding processor (not shown) can process the reconstructed video data. For example, post-decoding processing can include an inverse color model transform (e.g., conversion from YUV 4:2:0 to RGB 4:4:4) or an inverse mapping to reverse the mapping process performed by the pre-encoding processor described with respect to FIG. 2. The post-decoding processor can use metadata derived by the pre-encoding processor and/or signaled in the video bitstream.

Systems, methods, and instrumentalities are disclosed for entropy coding of on the border predicted probabilities. A context adaptive binary arithmetic coding (CABAC) probability associated with a bit may be determined. A range of a least probable symbol (LPS) may be determined based on the CABAC probability and a probability prediction threshold. The bit may be entropy decoded or encoded based on the range of the LPS.

In examples, the range of the LPS may be determined to be a minimum range value based on the CABAC probability being less than or equal to the probability prediction threshold. The probability prediction threshold may be a first probability prediction threshold. A second probability prediction threshold may be determined that is greater than the first probability prediction threshold.

In examples, the range of the LPS may be determined to be a minimum range value based on the CABAC probability being greater than or equal to the second probability prediction threshold. A CABAC range adjustment parameter may be obtained. An interval range may be determined based on the CABAC range adjustment parameter. The determined interval range may be updated based on the minimum range value of the range of the LPS.

In examples, the probability prediction threshold may be a first probability prediction threshold. A second probability prediction threshold may be determined that is greater than the first probability prediction threshold. A CABAC range adjustment parameter may be obtained. An interval range may be determined based on the CABAC range adjustment parameter. A condition may be that the CABAC probability is greater than the first probability prediction threshold and less than the second probability prediction threshold. The range of the LPS may be determined further based on the determined interval range.

In examples, it may be determined that the bit is a significant bit of a transform coefficient associated with a coding block. The determination of the range of the LPS may be further based on the bit being a significant bit which may show whether the coefficient is different than zero of the transform coefficient associated with the coding block.

In examples, it may be determined that the bit is a significant bit of a transform coefficient associated with a coding block. A quantization state associated with the significant bit may be determined to be an odd state. The determination of the range of the LPS may be further based on the determination that the bit is a significant bit of the transform coefficient associated with the coding block and the determination that the quantization state associated with the significant bit is an odd state. The transform coefficient may be an earliest transform coefficient of a plurality of transform coefficients associated with coding block.

Video coding may use an entropy coder and/or entropy decoder in a video codec. A Context Adaptive Binary Arithmetic Coder (CABAC) may use a dynamic model switch and/or parameterization.

A video codec may perform a large part of signaling, for example, using entropy coding of the values to transmit. CABAC may encode (e.g., only) binary values. Generic values may (e.g., first) undergo a binarization process, e.g., prior to CABAC encoding. A context may (e.g., also) be attached for a (e.g., each individual) bin to encode, for example, so that the probability of the (e.g., each) bin to encode may be updated after an (e.g., each) encoding/decoding. For example, the probability may be updated based on (e.g., according to) the value taken by the considered coded bin. The speed at which the probability is updated may be a parameter of the model (e.g., the probability model associated to the bin).

The speed at which the probability is updated and/or the initial probability used may be parameters of the model.

For each individual binary symbol (bin) to encode, a probability model may be attached, for example to represent the conditional probability of the bin being equal to 1 or 0. The probability model may depend on contextual information. The probability model may enable an average coding rate for the considered bin that is close to the theoretical lower bound defined by the conditional entropy of the binary symbol given the contextual information. This conditional entropy may be lower (e.g., is lower) than the non-contextual entropy, leading to a lower coding rate.

In the following, the probability of a bin may refer to the probability that the bin is equal to 1.

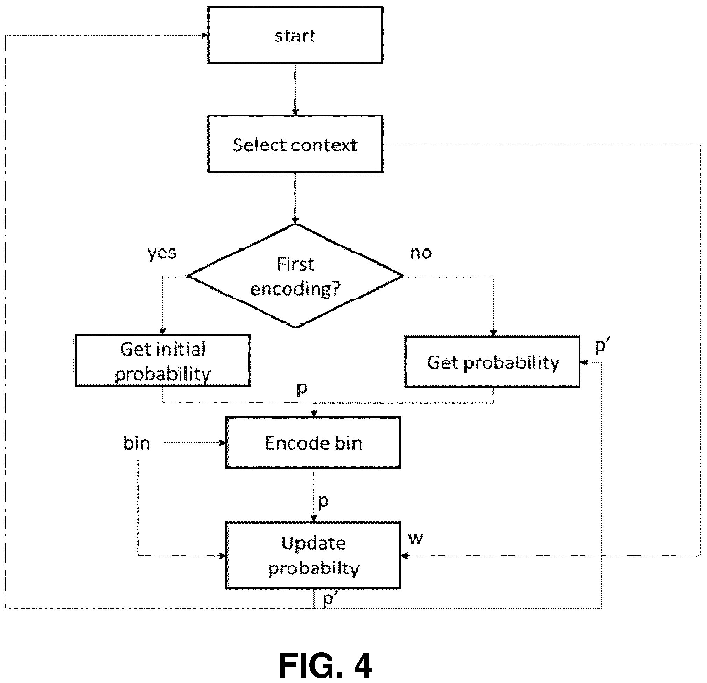

An example of entropy coding by a video codec is shown in FIG. 4. For example, a context may be selected, for example, for each bin. A (e.g., each) context may include, for example, one or more of the following information: current probability; windows size(s); a weighted sum of probabilities; parameters dw00, dw01, dw10, dw11, and/or an initial probability. A current probability may include one or more probabilities. For example, a codec may maintain two (2) probabilities, e.g., p0 and p1.

One or more window sizes may correspond, for example, to the update speed of a probability. A probability may be updated, for example, in accordance with Eq. (1):

$$p_{next} = \alpha * b + (1 - \alpha) * p \qquad\qquad (1)$$

where p may be the previous probability, $p_{next}$ may be the updated probability, b may be the current bin encoded/decoded, and a=1/2*w, where w may be the window size (e.g., which may determine the speed at which the probability is updated). For example, a codec may update two (2) probabilities using two (2) different window sizes, e.g., w0 and w1. A (e.g., each) bin may (e.g., then) be encoded/decoded, for example, by considering the weighted sum of the (e.g., two) probabilities (e.g., p0 and p1) using the weight a. Window size(s) may be updated, for example, each time a bin has been read, which may depend on one or more parameters, e.g., dw00, dw01, dw10, and/or dw11.

An initial probability may be created/maintained. One or more parameters (e.g., p0 and/or p1) may be initialized, for example, using an initial probability (e.g., the same initial probability).

The parameters for a given context (e.g., initial probability, windows sizes, weight between probabilities) may depend on one or more of the following (e.g., external) parameters: the type of slice to encode (e.g., intra (I), biprediction (B), or uni-direction (P)); and/or a quantization parameter qp.

A (e.g., each) context may use fixed (e.g., between encoder and decoder) parameters. The parameters may be decided, for example, per context.

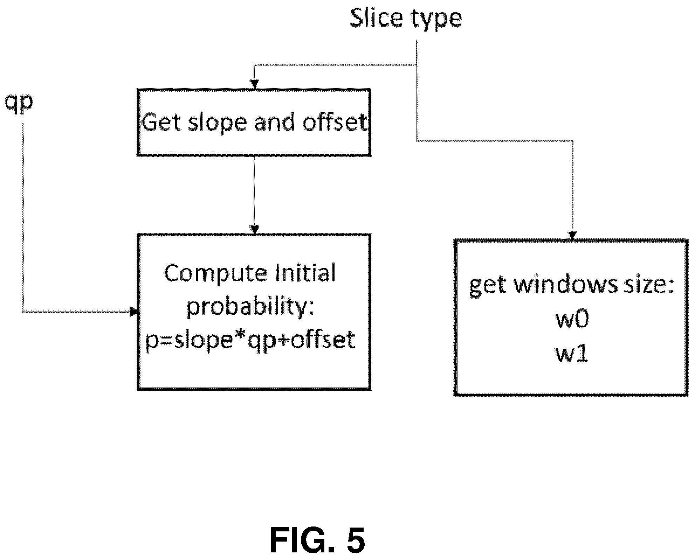

Parameters may be initialized, for example, at the beginning of a (e.g., each) slice, as depicted by example in FIG. 5. A flag (e.g., sh_cabac_init_flag) may be signaled in the slice header for a non intra slice. The indication provided by the flag may allow switching of the parameters that may be used for initialization, e.g., depending on the type of slice to encode. For example, if/when the flag is true for a B slice, a P slice parameter set may be used, and the other way around. Table 1 shows an example of syntax using the CABAC initialization flag.

Table 1 - Example of syntax using the CABAC initialization flag

| | |
|---|---|
| if( sh_slice_type != I ) { | |
| if( pps_cabac_init_present_flag ) | |
| **sh_cabac_init_flag** | u(1) |

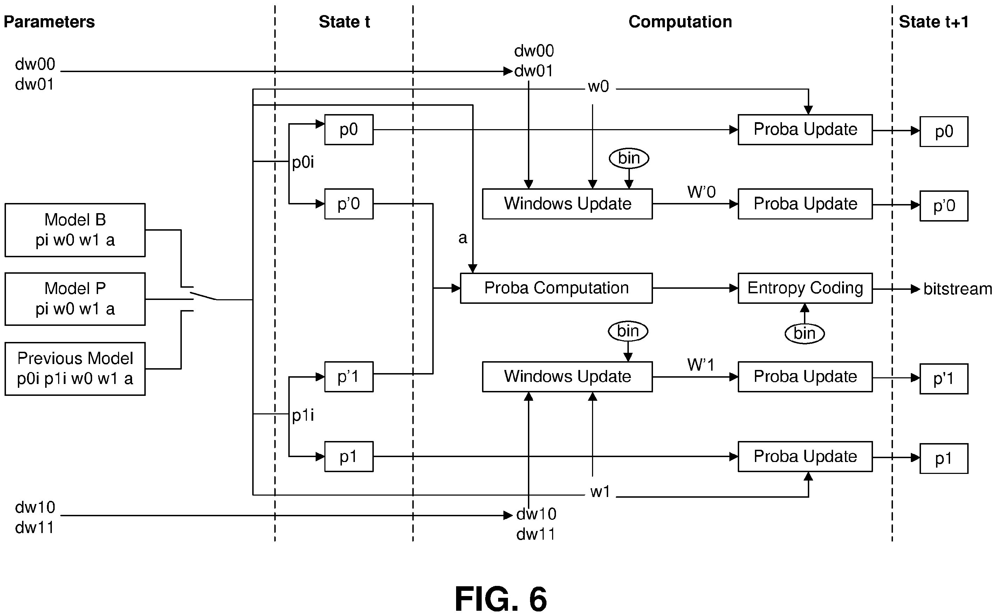

FIG. 6 illustrates an example of a CABAC engine. As shown in FIG. 6, the values of the parameters shown in FIG. 6 (e.g., parameter values) may be selected/fixed for a particular context. The example shows three contexts/parameter sets. For a B or P slice, a selection may be made between three (3) parameter sets: B, P, or previous model. In some examples (e.g., as shown in FIG. 6), the dw values may be shared for multiple (e.g., all) models (e.g., B, P, I, and/or previous model).

A bin may be encoded/decoded, for example, based on the value of p, which may depend on probabilities p'0 and p'1, for example, in accordance with Eq. (2):

$$p = a*p'0 + (1-a)*p'1 \qquad (2)$$

The probabilities p0 and p1 may (e.g., then) be updated, for example, depending on the bin value, which may be determined in accordance with Eqs. (3):

$$p0\_next = alpha0 * b + (1-alpha0) *p0, \text{ where } alpha0 = 1/2^{\wedge}w0 \qquad (3)$$

$$p1\_next = alpha1 * b + (1-alpha1) *p1, \text{ where } alpha1 = 1/2^{\wedge}w1$$

The windows size may be updated from w0 and w1 using the bin value and the dw parameters, for example, in accordance with Eqs. (4):

$$w'0 = w0 + dw0[b] \qquad (4)$$

$$w'1 = w1 + dw1[b]$$

The probability p'0 and p'1 may (e.g., then) be updated depending on the bin value, for example, in accordance with Eqs. (5):

$$p0'\_next = alpha0' * b + (1-alpha0') *p0, \text{ where } alpha0' = 1/2^{\wedge}w0' \qquad (5)$$

$$p1'\_next = alpha1' * b + (1-alpha1') *p1, \text{ where } alpha1' = 1/2^{\wedge}w1'$$

Entropy coding may use a CABAC, which may include, for example, one or more of the following: a core CABAC engine; a separate residual coding structure for a transform block and a transform skip block; and/or context modeling for transform coefficients.

A CABAC engine may use a table-based probability transition process between (e.g., 64) different representative probability states. A range (e.g., denoted ivlCurrRange) may represent the state of the coding engine. The range may be quantized to a set of (e.g., four (4)) values prior to the calculation of the new interval range. A state transition may be implemented, for example, using a table containing (e.g., 64×4 8-bit pre-computed) values to approximate the values of ivlCurrRange * pLPS( pStateIdx), where pLPS may be the probability of the least probable symbol (LPS) and pStateIdx may be the index of the current state. A decode decision may be implemented, for example, using a pre-computed look up table (LUT). A value of ivlLpsRange may (e.g., first) be obtained, for example, using the LUT. The value of ivlLpsRange may be determined, for example, in accordance with Eq. (6). The determined/looked-up value of ivlLpsRange may be used to update ivlCurrRange and/or to calculate the output binVal.

$$ivlLpsRange = rangeTabLps[ pStateIdx ][ qRangeIdx ] \qquad (6)$$

A probability may be linearly expressed, for example, by the probability index pStateIdx. Calculations may be performed with equations, e.g., without LUT operation. A multi-hypothesis probability update model may be applied, for example, to improve the accuracy of probability estimation. The pStateIdx used in the interval subdivision in the binary arithmetic coder may be a combination of (e.g., two) probabilities (e.g., pStateIdx0 and pStateIdx1). The (e.g., two) probabilities may be associated with each context model. The probabilities may be updated independently, for example, with different adaptation rates. The adaptation rates of pStateIdx0 and pStateIdx1 for each context model may be pre-trained, for example, based on the statistics of the associated bins. The probability estimate pStateIdx may be the weighted average of the estimates from the (e.g., two) hypotheses.

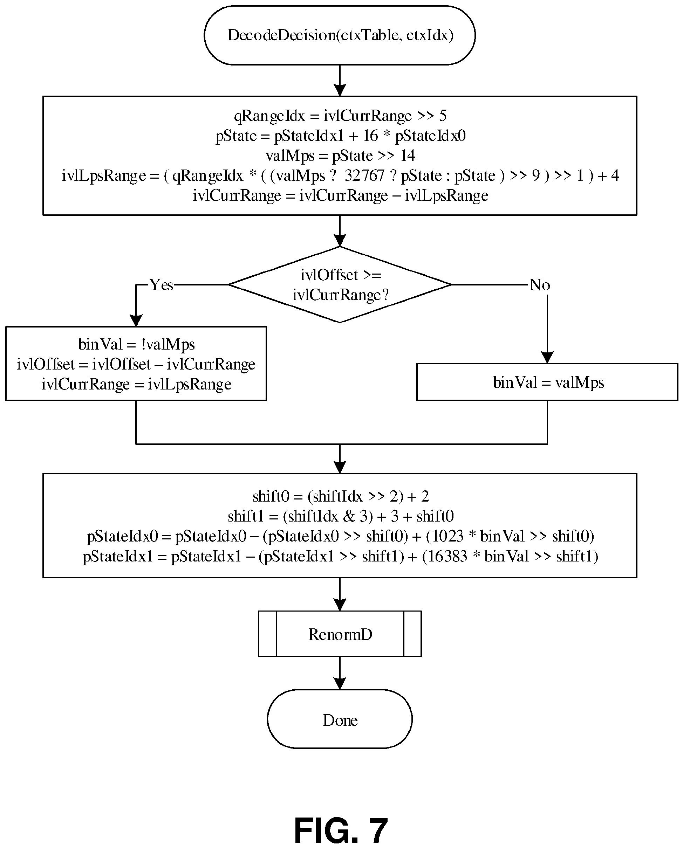

FIG. 7 illustrates a flowchart showing an example for decoding a (e.g., single) binary decision. A CABAC may (e.g., also) have a QP dependent initialization process, which may be invoked at the beginning of a (e.g., each) slice. An initial value of luma QP for the slice may be given/selected/determined. The initial probability state of a context model, denoted as preCtxState, may be derived, for example, in accordance with Eq. (7) - Eq. (11) as follows:

$$m = slopeIdx \times 5 - 45 \qquad (7)$$

$$n = (offsetIdx << 3) +7 \qquad (8)$$

$$preCtxState = Clip3(1, 127, ((m \times (QP - 32)) >> 4) + n) \qquad (9)$$

where slopeIdx and offsetIdx may be restricted to a number of bits (e.g., 3 bits). Total initialization values may be represented by a (pre)determined precision (e.g., 6-bit precision). The probability state preCtxState may represent the probability in the linear domain, e.g., directly. Probability state preCtxState may need (e.g., only) proper shifting operations before being input into an arithmetic coding engine. The logarithmic to linear domain mapping and/or the table (e.g., 256-byte table) may be saved.

$$pStateIdx0 = preCtxState << 3 \qquad (10)$$

$$pStateIdx1 = preCtxState << 7 \qquad (11)$$

Entropy coding may be implemented with selected precision. Intermediate precision that may be used in an arithmetic coding engine may be increased, for example, including multiple (e.g., three) elements. The precision for (e.g., two) probability states may be, for example, 15 bits, e.g., in comparison to 10 bits and 14 bits in some examples. The LPS range update process may be determined, for example, in accordance with Eq. (12) and accompanying logic:

$$\text{if } q >= 16384$$
$$q = 2^{15} - 1 - q$$
$$R_{LPS} = ((range * (q>>6)) >>9) + 1 \qquad (12)$$

where range may be a (e.g., 9-bit) variable representing the width of the current interval, q may be a (e.g., 15-bit) variable representing the probability state of the current context model, and $R_{LPS}$ may be the updated range for LPS. The operation may (e.g., also) be realized, for example, by looking up an entry (e.g., a $512 \times 256$-entry) in a (e.g., 9-bit) look-up table. At the encoder side, the look-up table used for bits estimation may be implemented, for example, with 256 or 512 entries.
Window size may be based on slice type. Statistics may be different with different slice types. A context probability state may be updated at a rate that may be optimal under the given slice type. For example, three window sizes may be pre-defined for I-slices, B-slices, and P-slices, respectively, as the initialization parameters for a (e.g., each) context model. The context initialization parameters and/or window sizes may be retrained.
In some examples, update rates may be adaptive (e.g., adaptive update rates). In some examples, the probability state used for coding may be a weighted average. In some examples, a state may be carried-over/inherited.
Update rules may be implemented for the (e.g., two) probability states, e.g., pStateIdx0 and pStateIdx1. Encoding of the n-th bit of a context may be performed using probability states pStateIdx0' and pStateIdx1', which may be obtained from pStateIdx0 and pStateIdx1 using window sizes that may depend on the (n-1)-th bin, for example, in accordance with Eq. (13) and Eq. (14):

$$w0'(n) = w0 + d0(b_{n-1})$$

$$w1'(n) = w1 + d1(b_{n-1})$$

$$pStateIdx0'(n) = (1-1/2^{w0'(n)})*pStateIdx0(n-1) + 1/2^{w0'(n)}*b_{n-1} \qquad (13)$$

$$pStateIdx1'(n) = (1-1/2^{w1'(n)})*pStateIdx1(n-1) + 1/2^{w1'(n)}*b_{n-1} \qquad (14)$$

and d0(b), d1(b) are lookup tables on offset values d00,d01,d10,d11 defined at init for the context, added to the window size w0,w1.
The probability state used for coding may be a weighted average of pStateIdx0' and pStateIdx1' (e.g., instead of a simple average), for example, in accordance with Eq. (15):

$$pStateIdx(n) = a*pStateIdx0'(n) + (1-a)*pStateIdx1'(n) \quad\quad (15)$$

where the parameter alpha (e.g., a in FIG. 6) may be obtained, for example, from an LUT. The parameter alpha (a) may depend on the context and/or on the slice type.

The initial state of one or more (e.g., some) B or P-slices may be inherited from previous slices, for example, instead of being re-initialized at each slice. For example, the two final states of each B-slice (or P-slice) may be stored and used to initialize the next B-slice (or P-slice) in the same intra-period sharing the same temporal level and qp.

The efficiency of the entropy coding may depend on the accuracy of the probability estimation of the coming bits and/or the ability of the CABAC engine to encode coming bits (e.g., precisely) with the predicted probability. For example, if the coming bit's true probability of being 1 is p, an (e.g., the best) entropy coding may spend a number of bits for encoding that specific bit b calculated by:

$$cost = (b - 1)\log_2(1 - p) - b\log_2(p)$$

b is the specific bit that may be either 0 or 1. This cost may get smaller if the probability of being 1 (p) goes to 1 when b=1, and/or if the probability p goes to 0 when b=0. Due to the less accurate probability estimation and the resolution of the CABAC engine to perform encoding for given probability, there may be a mismatch between the true probability p and the probability that CABAC engine uses $\hat{p}$. The obtained cost from the CABAC engine may be:

$$\widehat{cost} = (b - 1)\log_2(1 - \hat{p}) - b\log_2(\hat{p})$$

The differences between the obtained cost and the theoretical limit ($\widehat{cost} - cost$) may show how much the CABAC engine spends extra bits to encode coming bits compared to a physical limit.

This mismatch may be inevitable due to the finite resolution of the CABAC engine to perform probabilities and/or less accurate probability prediction. If (e.g., however) the estimated probability is on the border or is (e.g., very) high (e.g., close to 1) or (e.g., very) low (e.g., close to 0), there may be a systematic error between $p$ and $\hat{p}$. This systematic error may be overcome and/or avoided and coding efficiency may be improved.

The performed probability by the CABAC engine may be lower than the true probability if the predicted probability is close to 1 and/or the performed probability by the CABAC engine is higher than the true probability if the predicted probability is close to 0. The probabilities may be increased if it is close to 1, or decreased if it is close to 0.

The CABAC engine may need bits to encode and its 15-bit integer representation of the probability in the process:

Algorithm: encode(b, $\hat{p}$):

Set range=510, low=0

For each b, $\hat{p}$ $in$ (b, $\hat{p}$)

q= $Q(\hat{p}, 15)$ // represent predicted probability by 15 bit integer

if $q$>= 16384

q = $2^{15} - 1 - q$

$R_{LPS}$ = ((range * (q>>6)) >>9) + 1,

Update range and low according to b and RLPS

Endfor

Produce $bitstream$ from low.

In the default decoding process, the CABAC engine may need a bitstream and/or a predicted probability to decode the bit:

Algorithm: decode($bitstream, \hat{p}$):

Set range=510, read initial bytes of val from $bitstream$

For each $\hat{p}$ $in$ $(\hat{p})$

q= $Q(\hat{p}, 15)$ // represent predicted probability by 15 bit integer

if $q$>= 16384

q = $2^{15} - 1 - q$

R$_{LPS}$ = ((range * (q>>6)) >>9) + 1,

Update range and val according to b and RLPS

Find b by range and val.

Store b in b

If necessary read more bytes of val from bitstream

Endfor

Return b.

The (e.g., all) bits may be encoded. Their probabilities may be in the border and those bits may be assumed to be 1 or 0 depending on if their predicted probabilities are on (e.g., near) the lower limit or upper limit. The resolution of the CABAC's arithmetic encoder range limit may be increased so that a new CABAC may be introduced to perform entropy coding by lower than the previously lowest probability or higher than the previously highest probability.

If the predicted probability is higher than any threshold (e.g., *th*1) assuming it is 1, it may be determined to skip encoding (e.g., not encode anything). If the predicted probability is lower than any threshold (e.g., *th*1i*),* assuming it is 0, it may be determined to skip encoding (e.g., not encode anything).

A device (e.g., an encoder and/or a decoder) may determine a CABAC probability. The device may skip entropy coding (e.g., encoding or decoding) a bit based on the CABAC probability and one or more probability prediction thresholds. The device may assign a fix value to the bit based on the CABAC probability and a probability prediction threshold. For example, the device may assign a first fixed value (e.g., 1) to a bit if the CABAC probability is greater than a first threshold. The device may assign a second fixed value (e.g., 0) to a bit if the CABAC probability is less than a second threshold. In examples, the CABAC probability may be updated based on an assigned value (e.g., the CABAC probability value may be updated every time a fixed value 0 or 1 is assigned to a bit).

A proposed encoding and decoding algorithm may be:

**Algorithm**: encode1(b, $\hat{p}, th0, th1$):

```
If p̂ ≥ th0 and p̂ ≤ th1:
  Return encode(b, p̂)
Else
  Return Ø
End


Algorithm: decode1(bitstream, p̂, th0, th1):
If p̂ < th0
  Return 0;
Else if p̂ > th1:
  Return 1;
Else
Return decode(bitstream, p̂)
End
```

Probabilities may be set to 0 or 1 if the predicted probability is close to the lowest or highest possible probability respectively. New costs may be shown compared to the default CABAC.

|  | Default Costs | | Proposed Costs | |
|---|---|---|---|---|
|  | b=0 | b=1 | b=0 | b=1 |
| $\hat{p} > th1$ | $-\log_2(1 - \hat{p})$ | $-\log_2(\hat{p})$ | ∞ | 0 |
| $p < th0$ | $-\log_2(1 - \hat{p})$ | $-\log_2(\hat{p})$ | 0 | ∞ |

According to the table, if $\hat{p} > th1$ and b=1 or if $\hat{p} < th0$ and b=0, 0 bits may be spent to encode them. The CABAC engine (e.g., default CABAC engine) may spend $-\log_2(\hat{p})$ and $-\log_2(1 - \hat{p})$ respectively. There may (e.g., always) be a gain in those cases. However, if $\hat{p} > th1$ and b=0 or if $\hat{p} < th0$ and b=1, the encoder may need an infinite number of bits to encode them which means it is not possible, thus encoding does not work. However, an engine (e.g., a default engine) may (e.g., still) manage to encode these cases with the cost of $-\log_2(1 - \hat{p})$ and $-\log_2(\hat{p})$ respectively. Quantization and RD search algorithm may be made aware of this point and the encoder may not (e.g., never) produce the bits which need an infinite number of bits to encode.

If a CABAC engine (e.g., a default CABAC engine) is used to overcome a (e.g., infinite) bit cost issue, an entropy coding may be selected to be used from the following: for all bits, for all bits of the transform coefficients, for just significant bit of the transform coefficients, for just significant bit of the transform coefficients when quantization state is odd, or for just significant bit of the first transform coefficient in the coding block when quantization state is odd. Problematic bits may be prevented during the Quantization process. Quantization may not (e.g., never) produce those problematic bits. Problematic bits may be prevented during a Rate Distortion (RD) search, which may punish (e.g., downgrade) the solutions which include those problematic bits.

In an example, 32720 may be used for upper and 48 for lower threshold probabilities. This may be applied for all bits of the transform coefficients. During an encoder RD search, the solution that includes problematic bins may be punished (e.g., downgraded). The pseudo code may be as follows.

For each solution during RD search:
  If solution has (b ∈ Transform coefficient) and (($\hat{p} > 32720$ and b=0) or ($\hat{p} < 48$ and b=1))
    Neglect that solution
  Else
    Validate this solution
  Endif
Endfor

During the encoding process, the pseudo-code may be as follows.

If b ∈ Transform coefficient
  encode1(b, $\hat{p}$, 48,32720):
Else
  encode(b, $\hat{p}$):
Endif

The pseudo-code of its decoding process may be as follows.

If b ∈ Transform coefficient
  decode1($bitstream, \hat{p}$, 48,32720):
Else
  decode($bitstream, \hat{p}$):
Endif

In examples, entropy coding may be used for the first transform coefficient's significant bits if it is in odd states of a Trellis Coded quantization (TCQ) process. In TCQ, there are 8 states (e.g., solution candidates) and odd states tend to produce more 1s rather than 0s for significant bits. In the following code, the quantization process may be modified on the odd states (e.g., 1,3,5, and $7^{th}$ state) when the coefficient's scanIdx is 0 (e.g., it is the first coefficient in the block) in order to prevent TCQ to assign 0 to this coefficient's significant bits.

```
if (spt.scanIdx==0) // proposed part
{
    m_prevStates[0].checkRdCosts(spt.spt, pqData[0], pqData[2], decisions[0], decisions[2]);
    m_prevStates[1].checkRdCostsNoSigf(spt.spt, pqData[3], pqData[1],pqData[4], decisions[5], decisions[7]);
    m_prevStates[2].checkRdCosts(spt.spt, pqData[0], pqData[2], decisions[1], decisions[3]);
    m_prevStates[3].checkRdCostsNoSigf(spt.spt, pqData[3], pqData[1],pqData[4], decisions[6], decisions[4]);
```

```
            m_prevStates[4].checkRdCosts(spt.spt, pqData[0], pqData[2], decisions[2], decisions[0]);
            m_prevStates[5].checkRdCostsNoSigf(spt.spt, pqData[3], pqData[1],pqData[4], decisions[4],
decisions[6]);
            m_prevStates[6].checkRdCosts(spt.spt, pqData[0], pqData[2], decisions[3], decisions[1]);
            m_prevStates[7].checkRdCostsNoSigf(spt.spt, pqData[3], pqData[1],pqData[4], decisions[7],
decisions[5]);


        }
        Else // default part
        {
            m_prevStates[0].checkRdCosts(spt.spt, pqData[0], pqData[2], decisions[0], decisions[2]);
            m_prevStates[1].checkRdCosts(spt.spt, pqData[3], pqData[1], decisions[5], decisions[7]);
            m_prevStates[2].checkRdCosts(spt.spt, pqData[0], pqData[2], decisions[1], decisions[3]);
            m_prevStates[3].checkRdCosts(spt.spt, pqData[3], pqData[1], decisions[6], decisions[4]);
            m_prevStates[4].checkRdCosts(spt.spt, pqData[0], pqData[2], decisions[2], decisions[0]);
            m_prevStates[5].checkRdCosts(spt.spt, pqData[3], pqData[1], decisions[4], decisions[6]);
            m_prevStates[6].checkRdCosts(spt.spt, pqData[0], pqData[2], decisions[3], decisions[1]);
            m_prevStates[7].checkRdCosts(spt.spt, pqData[3], pqData[1], decisions[7], decisions[5]);
        }
```

Since the problematic bits are guaranteed to not to be inside the bit to be encoded, encoding may be applied as follows.

```
        If b ∈ The first Transform coefficient's significant bit
```
$$bitstream = \text{encode1}(\mathbf{b}, \hat{p}, 48, 32720):$$
```
        Else
```
$$bitstream = \text{encode}(\mathbf{b}, \hat{p}):$$
```
        Endif
```

Thus, the pseudo-code of its decoding process can be as follows.

```
        If b ∈ The first Transform coefficient's significant bit
```
$$\mathbf{b} = \text{decode1}(bitstream, \hat{p}, 48, 32720):$$
```
        Else
```
$$\mathbf{b} = \text{decode}(bitstream, \hat{p}):$$
```
        Endif
```

The solution is not punished during the encoder side RD search or in quantization process. Since this approach allows to encode any bits, RD search and quantization process may work (e.g., as the default). The resolution of the range of the CABAC engine may be changed, for example, in order to go lower than the lowest probability or higher than the highest probability.

The CABAC engine may find LPS range update ($R_{LPS}$) by using 15-bit probability prediction shown by q (if q=32768 it means $\hat{p} = 1$.) In one or more examples as described herein and current range of arithmetic encoder by following equation.

if

$$q >= 16384$$

$$q = 2^{15} - 1 - q$$

$$R_{LPS} = ((range * (q>>6)) >>9) + 1,$$

$R_{LPS}$ may define the cost of an encoding bit whose probability prediction may be q and range may be 9 bit integer. In settings (e.g., default settings), the range may be between 0-511, q may be between 0-32767, and RLPS may be 1-255 (e.g., the minimum range value for RLPS may be one).

When q is lower than 64 or greater than 32704, q»6 may become 0 and $R_{LPS}$ may have a (e.g., minimum) value of 1. The CABAC engine may not work differently as long as the prediction is higher than 32704 or lower than 64. The range may be multiplied by $2^n$ (e.g., n may be used to denote a range adjustment parameter). A 9+n bit integer may be presented. The RLPS may be multiplied by $2^n$. If n=1, our range may be between 0-1023 and RLPS may take a value of 2, 4, 6, ..., 510, etc. Since both range and RLPS may be doubled, the cost 2*RLPS/range may be the same. RLPS may be forced to be 1 if the q is on the border region. We can lower the minimum bit length from 1/255 bits to 1/510 bits.

The proposed encoding and decoding algorithm may be as follows.

> **Algorithm**: encode2(**b**, $\hat{\boldsymbol{p}}$, $th0$, $th1$, $n$):
> Set **range**=510<<n, **low**=0
> For each b, $\hat{p}$ $in$ (**b**, $\hat{\boldsymbol{p}}$)
>   q= $Q(\hat{p}, 15)$ // *represent predicted probability by 15 bit integer*
>   if  q>= 16384
>   q = $2^{15} - 1 - q$
>   $R_{LPS}$ = ((((**range**>>n) * (q>>6)) >>9) + 1)<<n,
>   If q<=th1 or q>=th0
>     $R_{LPS}$ =1
>   Update **range** and **low** according to b and RLPS
> Endfor
> Produce $bitstream$ from **low**.

As shown herein, $\hat{p}$ may be used to denote a CABAC probability. A probability prediction threshold (e.g., *th*0 and/or *th*1) may be used in one or more examples herein. **Range** may be used to denote an interval range.

In a decoding process (e.g., the default decoding process), CABAC engine may need bitstream and predicted probability to decode the bit, shown in the following process by:

> **Algorithm**: decode2($bitstream$, $\hat{\boldsymbol{p}}$, $th0$, $th1$, $n$):
> Set **range**=510<<n, read initial bytes of **val** from $bitstream$
> For each $\hat{p}$ $in$ ($\hat{\boldsymbol{p}}$)
>   q= $Q(\hat{p}, 15)$ // *represent predicted probability by 15 bit integer*
>   if  q>= 16384
>   q = $2^{15} - 1 - q$
>   $R_{LPS}$ = ((((**range**>>n) * (q>>6)) >>9) + 1)<<n,
>   If q<=th1 or q>=th0
>     $R_{LPS}$ =1
>   Update **range** and **val** according to b and RLPS
>
>   Find b by **range** and **val.**
>   Store b in **b**
>   If necessary read more bytes of **val** from bitstream
> Endfor
> Return **b**.

An entropy coding (e.g., encoding and/or decoding) may be selected from the following, for example: for one or more (e.g., all) bits, for one or more (e.g., all) bits of the transform coefficients, for just a significant bit (e.g., a bit that shows whether a coefficient is different than zero) of the transform coefficients, for just a significant bit of the transform coefficients when quantization state is odd, and/or for just a significant bit of the first transform coefficient in the coding block when quantization state is odd. In examples, a significant bit may be 1 if the coefficient is not zero, and/or the significant bit may be 0 if the coefficient is zero).

In an (e.g., a third) embodiment, 32720 may be used for upper and 48 for lower threshold probabilities. This may be applied for all bits in Transform coefficient. Double precision range may be used where n=1.

In an encoding process, the pseudo-code may be:

$$\text{If } b \in \text{Transform coefficient}$$
$$bitstream = \text{encode2}(\mathbf{b}, \widehat{\boldsymbol{p}}, 48, 32720, 1):$$
$$\text{Else}$$
$$bitstream = \text{encode}(\mathbf{b}, \widehat{\boldsymbol{p}}):$$
$$\text{Endif}$$

Thus, the pseudo-code of its decoding process can be as follows.

$$\text{If } b \in \text{Transform coefficient}$$
$$\mathbf{b} = \text{decode2}(bitstream, \hat{p}, 48, 32720, 1):$$
$$\text{Else}$$
$$\mathbf{b} = \text{decode}(bitstream, \hat{p}):$$
$$\text{Endif}$$

In an (e.g., a fourth) embodiment, 32720 may be used for upper and 48 for lower threshold probabilities. This may be applied for all bits that goes to theCABAC engine. Four times higher precision range may be used if n=2.

Encoding and decoding may be:

$$bitstream = \text{encode2}(\mathbf{b}, \widehat{\boldsymbol{p}}, 48, 32720, 2):$$

$$\mathbf{b} = \text{decode2}(bitstream, \widehat{\boldsymbol{p}}, 48, 32720, 2):$$

One or more embodiments provide a computer program comprising instructions which when executed by one or more processors cause such processors to perform the encoding and/or decoding methods according to any of the embodiments described above. One or more embodiments also provide a computer readable storage medium having stored thereon instructions for encoding or decoding video data according to the methods described above.

One or more embodiments provide a computer readable storage medium having stored thereon video data generated according to the methods described above. One or more embodiments also provide a method and apparatus for transmitting or receiving video data generated according to the methods described above.

The embodiments described herein may be implemented in, for example, a method or a process, an apparatus, a software program, a data stream, or a signal. Even if only discussed in the context of a single form of implementation (e.g., as a method), the implementation of such features may also be implemented in other forms. An apparatus may be implemented in, for example, appropriate hardware, software, and firmware. Corresponding methods may be implemented in, for example, a processor.

Various methods and aspects described herein can be used to modify one or more modules. For example, the intra predictors and inter predictors described with respect to FIGs. 2 and 3 may be implemented as one or more modules and modified according to the various embodiments of the present disclosure.

The various embodiments described herein provide at least the following features, devices or aspects, alone or on any combination, across various claim categories and types:

i. Encoding, into coded video data, syntax elements that can enable the decoder to decode the coded video data, according to any of the embodiments described herein.

ii. Video data (e.g., a bitstream) that may include one or more of the described syntax elements, or variations thereof, whether transmitted, stored, or otherwise made available.

iii. Creating, transmitting, receiving, and/or decoding of the bitstream.

iv. An electronic device (e.g., TV, set-top box, mobile phone, tablet, etc.) that tunes a channel to receive a bitstream or that receives such bitstream over the air. The electronic device decodes the syntax elements from the bitstream, and, optionally, displays (e.g., via a monitor or other type of display) a resulting image.

Various numeric values are used in the present application. Such specific values are for example purposes and the embodiments described are not limited to these specific values.

Various methods are described herein, and such methods comprise one or more steps or actions for achieving the described method. Unless a specific order of steps or actions is required for the proper operation of the method, the order and/or use of specific steps and/or actions may be modified or combined. Additionally, terms such as "first", "second", etc. may be used in various embodiments to modify an element, component, step, operation, etc., for example, a "first decoding" and a "second decoding". Use of such terms does not imply an order to the operations unless specifically required.

The present disclosure may refer to "determining" various pieces of information. Determining information may include one or more of, for example, estimating, calculating, predicting, or retrieving (e.g., from memory) the information.

The present disclosure may refer to "accessing" various pieces of information. Accessing information may include one or more of, for example, receiving, retrieving (e.g., from memory), storing, moving, copying, calculating, determining, predicting, or estimating the information. Similarly, the present disclosure may refer to "receiving" various pieces of information. Receiving information may include one or more of, for example, accessing or retrieving (e.g., from memory) the information.

"Decoding," as used herein, encompasses all or part of the processes performed, for example, on an encoded sequence to produce an output suitable for display. In some embodiments, such processes include one or more of the processes typically performed by a decoder, for example, entropy decoding, inverse quantization, etc. Whether the phrase "decoding process" is intended to refer to a subset of operations or generally to the broader decoding process will be clear based on the context of the specific description and will be well understood by those skilled in the art.

"Encoding," as used herein, encompasses all or part of the processes performed, for example, on input video data an order to produce an encoded bitstream. Additionally, the terms "reconstructed" and "decoded" may be used interchangeably, the terms "encoded" or "coded" may be used interchangeably, the terms "image," "picture," "sub-picture," "slice," and "frame" may be used interchangeably, and the terms "pixel" and "sample" may be used interchangeably.

The present disclosure refers to information, for example, syntax elements, that can be transmitted or stored. Such information can be packaged or arranged in a variety of manners, including for example manners common in video standards such as putting the information into a sequence parameter set (SPS), a picture parameter set (PPS), a network abstraction layer (NAL) unit, a header (for example, a NAL unit header, or a slice header), or an SEI message. Other manners are also available, including, for example, manners that are common for system level or application-level standards such as signaling the information into one or more of the following:

i. session description protocol (SDP), for example as described in RFCs and/or used in conjunction with real-time transport protocol (RTP) transmission.

ii. hypertext transfer protocol (HTTP) live Streaming (HLS) manifest transmitted over HTTP.

iii. dynamic adaptive streaming over HTTP (DASH) media presentation description (MPD) descriptors, for example as used in DASH and transmitted over HTTP.

iv. RTP header extensions, for example as used during RTP streaming.

v. International Organization for Standardization (ISO) base media file format, for example, as used in Omnidirectional MediA Format (OMAF).

As used herein, "signal" and "signaling" refer to, among other things, indicating information to a decoder. For example, in some embodiments the encoder signals a quantization matrix for de-quantization, whereby the same parameter may be used for both encoding and decoding. In some embodiments, the signaling may be explicit, such that information (e.g., a particular parameter) is transmitted to the decoder enabling the decoder to use the same particular parameter. In some embodiments, the signaling may be implicit, in that the information (e.g., a particular parameter) is indicated based on other information at or transmitted to the decoder or derived or selected by the decoder based on information available at the decoder. By not transmitting the information (e.g., the particular parameter), bit savings is thus realized in some embodiments. In some embodiments, one or more syntax elements or flags are used to signal information to a decoder. While the preceding relates to the verb form of the word "signal", the word "signal" can also be used herein as a noun.

In some embodiments, signals may be produced that are formatted to carry information that may be stored or transmitted. Such information may include, for example, instructions for performing a method, or data produced by one of the described implementations (e.g., a bitstream of a described embodiment). Such a signal may be formatted, for example, as an electromagnetic wave or as a baseband signal. The formatting may include, for example, encoding a data stream and modulating a carrier with the encoded data stream. The information that the signal carries may be, for example, analog or digital information. The signal may be transmitted over a variety of different wired or wireless links and may be stored on a processor-readable medium.

It is to be understood that use of any of the following "/", "and/or", and "at least one of" is intended to encompass all possible selections of listed items, taken either individually or in any combination thereof.

While specific embodiments have been described in the foregoing description in connection with the accompanying drawings, it should be understood that embodiments described herein are examples only and should not be taken as limiting the scope of the present disclosure or the following claims. Although features and elements are described herein in particular combinations, those of ordinary skill in the art will appreciate that such features or elements may be used alone or in any combination with the other features and elements. It is understood, therefore, that the overall teachings of the present disclosure are not limited to the particular embodiments, implementations, and examples disclosed herein, but are intended to cover variations, modifications, and alternatives as defined by the appended claims and any and all equivalents thereof.

## Claims

1. A device for video decoding, comprising:
   a processor configured to:

   determine a context adaptive binary arithmetic coding (CABAC) probability associated with a bit;
   determine a range of a least probable symbol (LPS) based on the CABAC probability and a probability prediction threshold; and
   entropy decode the bit based on the range of the LPS.

2. A device for video encoding, comprising:
   a processor configured to:

   determine a context adaptive binary arithmetic coding (CABAC) probability associated with a bit;
   determine a range of a least probable symbol (LPS) based on the CABAC probability and a probability prediction threshold; and
   entropy encode the bit based on the range of the LPS.

3. The device of claim 1 or claim 2, wherein the processor is further configured to determine the range of the LPS to be a minimum range value based on the CABAC probability being less than or equal to the probability prediction threshold.

4. The device of claim 1 or claim 2, wherein the probability prediction threshold is a first probability prediction threshold, and the processor is further configured to:

   determine a second probability prediction threshold that is greater than the first probability prediction threshold; and
   determine the range of the LPS to be a minimum range value based on the CABAC probability being greater than or equal to the second probability prediction threshold.

5. The device of claim 3 or claim 4, wherein the processor is further configured to:

   obtain a CABAC range adjustment parameter;
   determine an interval range based on the CABAC range adjustment parameter; and
   update the determined interval range based on the minimum range value of the range of the LPS.

6. The device of claim 1 or claim 2, wherein the probability prediction threshold is a first probability prediction threshold, and the processor is further configured to:

   determine a second probability prediction threshold that is greater than the first probability prediction threshold; and

17

obtain a CABAC range adjustment parameter; and

determine an interval range based on the CABAC range adjustment parameter, wherein, on a condition that the CABAC probability is greater than the first probability prediction threshold and less than the second probability prediction threshold, the range of the LPS is determined further based on the determined interval range.

7. The device of claim 1 or claim 2, wherein the processor is further configured to:
determine that the bit is a significant bit of a transform coefficient associated with a coding block, wherein the determination of the range of the LPS is further based on the bit being a significant bit of the transform coefficient associated with the coding block, and wherein the significant bit indicates whether the transform coefficient is different than zero.

8. The device of claim 1 or claim 2, wherein the processor is further configured to:

   determine that the bit is a significant bit of a transform coefficient associated with a coding block; and
   determine a quantization state associated with the significant bit is an odd state, wherein the determination of the range of the LPS is further based on the determination that the bit is a significant bit of the transform coefficient associated with the coding block and the determination that the quantization state associated with the significant bit is an odd state.

9. The device of claim 8, wherein the transform coefficient is an earliest transform coefficient of a plurality of transform coefficients associated with coding block.

10. A method for video decoding, comprising:

    determining a context adaptive binary arithmetic coding (CABAC) probability associated with a bit;
    determining a range of a least probable symbol (LPS) based on the CABAC probability and a probability prediction threshold; and
    entropy decoding the bit based on the range of the LPS.

11. A method for video encoding, comprising:

    determining a context adaptive binary arithmetic coding (CABAC) probability associated with a bit;
    determining a range of a least probable symbol (LPS) based on the CABAC probability and a probability prediction threshold; and
    entropy encoding the bit based on the range of the LPS.

12. The method of claim 10 or claim 11, further comprising determining the range of the LPS to be a minimum range value based on the CABAC probability being less than or equal to the probability prediction threshold.

13. The method of claim 10 or claim 11, wherein the probability prediction threshold is a first probability prediction threshold, and the method further comprises:

    determining a second probability prediction threshold that is greater than the first probability prediction threshold; and
    determining the range of the LPS to be a minimum range value based on the CABAC probability being greater than or equal to the second probability prediction threshold.

14. The method of claim 10 or claim 11, further comprising:

    obtaining a CABAC range adjustment parameter;
    determining an interval range based on the CABAC range adjustment parameter; and
    updating the determined interval range based on the minimum range value of the range of the LPS.

15. The method of claim 10 or claim 11, wherein the probability prediction threshold is a first probability prediction threshold, and the method further comprises:

    determining a second probability prediction threshold that is greater than the first probability prediction threshold; and

obtaining a CABAC range adjustment parameter; and

determining an interval range based on the CABAC range adjustment parameter, wherein, on a condition that the CABAC probability is greater than the first probability prediction threshold and less than the second probability prediction threshold, the range of the LPS is determined further based on the determined interval range.

**FIG. 1**

RF COMP USB HDMI — 105

PROCESSOR — 110

MEMORY — 120

DISPLAY INTERFACE — 160

DISPLAY DEVICE — 165

115

ENCODER/DECODER — 130

STORAGE DEVICE — 140

AUDIO INTERFACE — 170

AUDIO DEVICE — 175

PERIPHERAL INTERFACE — 180

COMMUNICATION INTERFACE — 150

PERIPHERALS — 185

COMMUNICATION CHANNEL — 190

100

EP 4 730 795 A1

ORIGINAL VIDEO → IMAGE PARTITIONER (202)

RESIDUAL BLOCKS → TRANSFORMER (220) → QUANTIZER (230) → ENTROPY ENCODER (245) → BITSTREAM

(210)

(240) INVERSE QUANTIZER → INVERSE TRANSFORMER (250) → RECONSTRUCTED RESIDUAL BLOCKS

PREDICTION BLOCKS

(255) → RECONSTRUCTED BLOCKS → IN-LOOP FILTERS (265) → REFERENCE PICTURE BUFFER (280)

INTRA PREDICTOR (260)

PREDICTION BLOCKS

PREDICTION ENHANCER (285)

(205)

MOTION COMPENSATOR (270)

MOTION ESTIMATOR (275)

200

FIG. 2

**FIG. 3**

EP 4 730 795 A1

**FIG. 4**

**FIG. 5**

EP 4 730 795 A1

**FIG. 6**

DecodeDecision(ctxTable, ctxIdx)

qRangeIdx = ivlCurrRange >> 5
pState = pStateIdx1 + 16 * pStateIdx0
valMps = pState >> 14
ivlLpsRange = ( qRangeIdx * ( ( valMps ? 32767 ? pState : pState ) >> 9 ) >> 1 ) + 4
ivlCurrRange = ivlCurrRange − ivlLpsRange

ivlOffset >= ivlCurrRange?

─Yes─     No

binVal = !valMps
ivlOffset = ivlOffset − ivlCurrRange
ivlCurrRange = ivlLpsRange

binVal = valMps

shift0 = (shiftIdx >> 2) + 2
shift1 = (shiftIdx & 3) + 3 + shift0
pStateIdx0 = pStateIdx0 − (pStateIdx0 >> shift0) + (1023 * binVal >> shift0)
pStateIdx1 = pStateIdx1 − (pStateIdx1 >> shift1) + (16383 * binVal >> shift1)

RenormD

Done

**FIG. 7**

Europäisches
Patentamt

European
Patent Office

Office européen
des brevets

# EUROPEAN SEARCH REPORT

**Application Number**

EP 24 30 6761

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/199046 A1 (CHUANG TZU-DER [TW] ET AL) 12 July 2018 (2018-07-12) | 1-7, 10-15 | INV.<br>H04N19/13<br>H03M7/40 |
| Y | * paragraph [0008] - paragraph [0024] *<br>* paragraph [0028] - paragraph [0030] *<br>* paragraph [0037] - paragraph [0057] *<br>----- | 8,9 | |
| Y | US 2020/344481 A1 (ZHOU MINHUA [US]) 29 October 2020 (2020-10-29)<br>* paragraph [0043] - paragraph [0065] *<br>----- | 8,9 | |
| X | US 2020/077117 A1 (KARCZEWICZ MARTA [US] ET AL) 5 March 2020 (2020-03-05)<br>* paragraph [0196] - paragraph [0219] *<br>----- | 1,2,10, 11 | |
| X | COBAN M ET AL: "Algorithm description of Enhanced Compression Model 11 (ECM 11)",<br>144. MPEG MEETING; 20231016 - 20231020; HANNOVER; (MOTION PICTURE EXPERT GROUP OR ISO/IEC JTC1/SC29/WG11),<br>,<br>no. m65800 ; JVET-AF2025<br>28 December 2023 (2023-12-28),<br>XP030313758,<br>Retrieved from the Internet:<br>URL:https://dms.mpeg.expert/doc_end_user/documents/144_Hannover/wg11/m65800-JVET-AF2025-v1-JVET-AF2025.zip JVET-AF2025-v1.docx [retrieved on 2023-12-28]<br>* Section 11.3.8.3 *<br>----- | 1,2,8,10 | |
| | -/-- | | TECHNICAL FIELDS SEARCHED (IPC)<br><br>H04N<br>H03M |

The present search report has been drawn up for all claims

| Place of search | Date of completion of the search | Examiner |
|---|---|---|
| Munich | 28 March 2025 | Vaquero, Raquel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

**Application Number**

EP 24 30 6761

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| L | SEREGIN (QTI QUALCOMM COM) V ET AL: "Exploration experiment on enhanced compression beyond VVC capability (EE2)", 36. JVET MEETING; 20241101 - 20241108; KEMER; (THE JOINT VIDEO EXPLORATION TEAM OF ISO/IEC JTC1/SC29/WG11 AND ITU-T SG.16 ), , no. JVET-AJ2024 8 November 2024 (2024-11-08), XP030326485, Retrieved from the Internet: URL:https://jvet-experts.org/doc_end_user/ documents/36_Kemer/wg11/JVET-AJ2024-v2.zip JVET-AJ2024-v2.docx [retrieved on 2024-11-08] * Test 3.5 * ----- | | |
| | | | TECHNICAL FIELDS SEARCHED (IPC) |

The present search report has been drawn up for all claims

| Place of search | Date of completion of the search | Examiner |
|---|---|---|
| Munich | 28 March 2025 | Vaquero, Raquel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 6761

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2025

| Patent document cited in search report | Publication date | Patent family member(s) | Publication date |
|---|---|---|---|
| US 2018199046 A1 | 12-07-2018 | BR 112019013916 A2 | 04-02-2020 |
| | | CN 110291793 A | 27-09-2019 |
| | | EP 3560201 A1 | 30-10-2019 |
| | | PL 3560201 T3 | 28-08-2023 |
| | | TW 201832554 A | 01-09-2018 |
| | | US 2018199046 A1 | 12-07-2018 |
| | | WO 2018127167 A1 | 12-07-2018 |
| | | ZA 201905142 B | 21-12-2022 |
| US 2020344481 A1 | 29-10-2020 | US 2018192053 A1 | 05-07-2018 |
| | | US 2020344481 A1 | 29-10-2020 |
| | | US 2022166983 A1 | 26-05-2022 |
| | | US 2022210424 A1 | 30-06-2022 |
| | | US 2024323385 A1 | 26-09-2024 |
| US 2020077117 A1 | 05-03-2020 | BR 112021003315 A2 | 11-05-2021 |
| | | CN 112640457 A | 09-04-2021 |
| | | EP 3847809 A1 | 14-07-2021 |
| | | SG 11202100622R A | 29-04-2021 |
| | | TW 202019178 A | 16-05-2020 |
| | | US 2020077117 A1 | 05-03-2020 |
| | | WO 2020051324 A1 | 12-03-2020 |

EPO FORM P0459